# EUROPEAN PATENT SPECIFICATION

(11) **EP 0 460 796 B1**
(45) Date of publication and mention of the grant of the patent: **29.10.1997**
(21) Application number: 91303527.5
(22) Date of filing: 19.04.1991
(51) Int. Cl.: C08J 7/06, B65D 65/40, C23C 14/10

(54) **Barrier materials useful for packaging**
Für Verpackung geeignete Sperrige Materialen
Matériaux de barrière utilisable dans les emballages

(30) Priority: 20.04.1990 US 513354; 20.04.1990 US 513302
(43) Date of publication of application: 11.12.1991
(73) Proprietor: E.I. DU PONT DE NEMOURS AND COMPANY, Wilmington Delaware 19898 (US)
(72) Inventor: Deak, Gedeon Imre, Wilmington, Delaware 19810 (US); Jackson, Scott Christopher, Kennett Square, Pennsylvania 19348 (US)
(74) Representative: Jones, Alan John

(56) References cited:
- EP-A- 0 062 334
- EP-A- 0 187 512
- EP-A- 0 311 432
- DE-A- 1 933 786
- FR-A- 2 247 737
- US-A- 3 442 686
- US-A- 4 552 791

## Description

### FIELD OF THE INVENTION

This invention relates to polymeric films having improved barrier properties towards oxygen and other materials.

### Description of Related Art

Flexible polymer films have been used extensively in the packaging of food, electronic and medical products. It is desirable in many applications to have a good barrier to oxygen and/or water vapor. However, most polymer based barrier resins such as ethylene vinyl alcohol copolymer ("EVOH") or polyvinylidene chloride ("PVDC"), although exhibiting good barriers to oxygen or moisture, do so only under ideal conditions. Although EVOH can be an excellent oxygen barrier, it loses its barrier property at moderate to high relative humidity. Thus this material is not widely usable in applications involving high water vapor content, such as moist foods. Although PVDC exhibits good moisture and oxygen barrier properties, it is not suitable for many applications, has an undesirable yellow color, and is difficult if not impossible to recycle. Other proposed alternatives to provide oxygen and water vapor barriers include laminations of aluminum foil and aluminum metallized film. Although these exhibit good barrier properties, they are completely opaque, cannot be recycled, and cannot be readily used for food packaging destined for use in a microwave oven.

U.S. Pat. 3,442,686 discloses multilayer structures as flexible transparent packaging film having good barrier properties to gases and liquids, comprising a flexible transparent organic polymeric base film having thereon an adherent, transparent, flexible highly gas- and liquid-impermeable, moisture resistant, continuous glassy coating of inorganic material, and a sealable, flexible, transparent top coating of organic polymeric material. The glassy coating is sandwiched between the base film and top coating. The preferred base films disclosed include polyester films such as Mylar® oriented, heat set polyester film. The preferred glassy coatings disclosed are the oxides of silicon and aluminum, and the coating thickness is disclosed to be 0.02 to 2 microns (20 to 2000 nm). Among the silicon oxides disclosed are silicon monoxide (SiO) and silicon dioxide (SiO₂). The glassy coating is formed on the base film by vacuum deposition. Examples of sealable top coatings disclosed are polyethylene and vinylidene chloride/acrylonitrile copolymer.

SiO is known to have better barrier properties than SiO₂, but unfortunately SiO is much more expensive than SiO₂ and imparts a yellow color to the package in the coating thickness required for development of its good barrier properties.

Nevertheless, after all the years since publication of U.S. Patent 3,442,686 in 1969, a commercial product has finally been introduced (in Japan) in which the glassy coating is a layer of SiO sandwiched between two layers of polyethylene terephthalate (PET) film and a cast polyolefin top coating to form a packaging film. For one of the products, the SiO layer thickness is on the order of 2000 Angstroms (200 nm). Another product consists of a laminate in which two superimposed layers of SiO are present, each having a thickness of 1200 Angstroms (120 nm), giving a total effective SiO thickness of 2400 Angstroms (240 nm). These products have two disadvantages. First the product has a distinctly yellow color arising from the SiO layer(s) at the layer thicknesses involved, ie., SiO has a yellow color, which becomes more intense as its thickness increases. It is believed that the yellow color of the SiO coating is somewhat ameliorated by carrying -out the vapor deposition of the coating in the presence of oxygen, whereby the SiO is on the order of SiO_{1.5}. Second, the packaging film constituting this commercial product has the disadvantage of high cost arising from the high thickness and high relative cost of SiO present in the packaging film to provide the needed barrier properties. To their credit, however, these packaging films are reported to be able to survive retorting at 125°C without loss of barrier property.

Effort has been made to use SiO₂ coating instead of SiO for economy reasons and in order to obtain a colorless package. To some extent, the barrier properties of SiO₂ can be improved by increased thickness, but there is a limit to this approach because of decreasing flexibility with increasing thickness.

U.S. Patent 4,702,963 (EP-A-0 062 334) discloses packaging film in which an adhesion layer is first vacuum deposited on a flexible polymer substrate, followed by vacuum deposition of a barrier layer, to confer retortability to the packaging film. The adhesion layer can consist of Cr, which is preferred, co-deposited mixtures of Cr and SiO having at least 20% by weight Cr, among others. The barrier layer is preferably silicon monoxide or silicon dioxide. When silicon dioxide is used, it may be mixed with glass modifiers such as oxides of Mg, Ba, and Ca, or with fluoride of alkaline earth metals, e.g. MgF₂. The glass modifiers serve to alter the color appearance of the overall coating. For example, a chromium/SiO composite film is disclosed to produce a coating with a yellowish appearance, while a neutral gray appearance is disclosed to result from the mixture of SiO₂ with glass modifiers. The specific adhesion/barrier layer systems disclosed in the Examples are primarily chromium as the adhesive layer and SiO or SiO₂ as the barrier layer. The lead-alumina silica glass is used as an adhesive layer, as is Ta-Cr alloy, Ta, Mo, and chromium oxides. In some Examples, the SiO₂ layer is mixed with a modifier. In Table 4, small changes in adhesion layer thickness are disclosed to greatly diminish light transmission. In addition, retortability is determined from a simulated test in which silicon oxide layer adhesion is reported after retorting but not any barrier property of the multilayer structure. The approach taken in this patent has not achieved commercialization.

Japanese patent application 60-244540 discloses a laminate comprising the formation on the surface of a plastic film a transparent thin layer of one or more materials selected from metals, metal oxides, or glass by means of a dry plating method, providing a laminate with good barrier properties. Suitable metals include aluminum, silicon, iron, gold, silver, copper, chromium, nickel, tin, titanium, and magnesium. Suitable oxides may be the oxides of these metals (such as silicon oxide, which can be mixtures of silicon monoxide and silicon dioxide), and glass. A mixed evaporation or multilayer evaporation may be performed.

Japanese patent application 61-47244 discloses a laminate of a plastic film or sheet on the surface of which has been formed a transparent thin layer by dry plating one or more of the materials selected from metals, oxides of the metals, and glass. Suitable metals include aluminum, silicon, titanium, tin, iron, gold, silver, copper, chromium, nickel, magnesium, or the like. The oxides are those of these metals, or glass. These metals and metal oxides may be evaporated in a mixed state to form a layer or evaporated to form a multilayer. The laminate is said to have excellent gas-barrier performance.

U.S. Patent 4,528,234 discloses a transparent laminate comprising a transparent plastic resin film substrate, a thin transparent layer of at least one metal such as aluminum, tin, iron, zinc, or magnesium formed on the substrate by vacuum deposition, and a carboxyl group-containing polyolefin (e.g. ionomer) layer formed on the metal layer by lamination. Optionally an additional layer of silicon oxide or titanium oxide may be present on one or both sides of the plastic film. Oxygen and moisture impermeability are said to be improved.

Japanese patent application 62-158677 discloses a transparent laminate wrapping material where a thin single or mixed metal oxide layer is an intermediate layer in a laminate structure. The laminate is said to have excellent gaseous oxygen and water vapor barrier properties. Silicon oxide and aluminum oxide-silicon oxide mixtures are effective.

Japanese patent application 62-156943 discloses a vapor-deposited layer built-in type multilayered gas-barrier film or sheet having two or more vapor-deposited layers of metals or metal compounds formed at one or more laminate interfaces of a multilayered synthetic resin film or sheet, having good gas barrier characteristics. Suitable metals include aluminum, zinc, copper, platinum, indium, tin, gold, silver, and silicon. A suitable metal compound is silicon oxide.

Chahroudi, "Glassy Barriers from Electron Beam Web Coaters," paper presented at Annual Technical Meeting of Society of Vacuum Coaters, discloses barriers of silicon oxide or SiO₂. Oxides of Mg, Ca, Ba, B, Al, In, Ge, Sn, Zn, Ti, Zr, Ce, and MgF₂ are disclosed as modifiers or replacements for silica.

Sakamaki, "Vapor Coating with Silicon Dioxide," discloses barrier properties of film with a thin layer of ceramic such as SiOₓ, in particular silicon oxide.

U.S. Patent 3,522,080 discloses a process for hardening the surface of a synthetic material such as a lacquer film, which includes vapor deposition of layers of silicon oxide (SiOₓ derived from SiO₂) onto the surface. The silicon oxide can contain 1.5 to 5 percent oxide of chromium, zinc, zirconium, or antimony.

U.K. patent application 2 197 881 discloses a heat resistant vessel made of a thermoplastic polyester resin by forming an inorganic coating layer comprising a silicon compound or a metal oxide-containing silicon compound on a surface of the polyester resin. The inorganic coating layer is obtainable from colloidal polysiloxane compounds. The coating material may further contain additives such as an inorganic filler of e.g. titanium oxide, zirconium silicate, nickel, copper oxide, manganese oxide, alumina, etc.

### SUMMARY OF THE INVENTION

The present invention provides a structure having superior barrier properties, comprising a polymeric substrate and a glassy coating of silicon dioxide doped with at least one metal selected from antimony, chromium cobalt, copper, indium, iron, manganese, tin, titanium, tungsten, zinc, and zirconium, said coating and metal dopant contained therein being present in an amount which provides an oxygen transmission value through the coated film structure of at most about 5 mL/day-m²-atm. Preferably the amount of metal dopant is sufficient to provide an oxygen permeation value for the glassy coating of at most about 3000 X 10⁻⁶ mL-mm/day-m²-atm. The structure may be a film and may comprise one or more layers of a multiple layer structure.

The invention further provides a process for imparting barrier properties to a polymeric substrate, comprising the steps of selecting a polymeric substrate and vacuum depositing onto the substrate a glassy coating prepared from silicon dioxide and at least one metal selected from antimony, chromium, cobalt, copper, indium, iron, manganese, tin, titanium, tungsten, zinc, and zirconium, wherein the amount of said glassy coating and the amount of metal contained therein is suitable to provide an oxygen transmission value through said film structure of at most about 5 mL/day-m²-atm.

### DETAILED DESCRIPTION OF THE INVENTION

The barrier films of the present inventions are polymeric substrates such as films, coated directly or indirectly with specially selected glass coatings. The polymeric substrates include any having suitable physical and thermal properties for the particular packaging application at hand. The minimum requirement is that they have sufficient thermal and physical properties to withstand the conditions of application of the glass coating, described in more detail below, and exhibit sufficient adhesion to the class coating. Examples of suitable substrates for use when the SiO₂ is coated directly onto the polymeric substrate include those prepared from polyamides, including amorphous and semicrystalline polyamides, polyethers, polyketones, polyester ethers, and polyesters (including polycarbonates), which are preferred.

Examples of polyester resins include polyethylene naphthalate, polycarbonate, and polyarylate, and most preferably polyethylene terephthalate ("PET"). Examples of semicrystalline polyamides include polycaprolactam (nylon 6) and condensation polymers of dicarboxylic acids and diamines, such as polyhexamethylene adipamide (nylon 6,6) etc. Examples of amorphous polyamides include hexamethylenediamine isophthalamide, hexamethylenediamine isophthalamide/terephthalamide terpolymer, having iso/terephthalic moiety ratios of 100/0 to 60/40, mixtures of of 2,2,4- and 2,4,4-trimethylhexamethylenediamine terephthalamide, copolymers of hexamethylene diamine and 2-methylpentamethylenediamine with iso- or terephthalic acids, or mixtures of these acids. Polyamides based on hexamethylenediamine iso/terephthalamide containing high levels of terephthalic acid moiety may also be useful particularly when a second diamine such as 2-methyldiaminopentane is incorporated to produce a processible amorphous polymer. Typically a substrate, especially a film, will have been oriented, optionally followed by heat setting so as to provide dimensional and thermal stability.

It is preferred that the substrate has a high surface smoothness. In particular when the substrate is polyethylene terephthalate it is preferred that the substrate has a smoothness such that the average height of roughness is less than about 50 nanometers, and most preferably less than about 10 nanometers, as measured on a WYKO™ optical profilometer, Model TOPO-3D from WYKO Co., Tuscon, AZ. Most ordinary PET films have a relatively large degree of surface roughness because of the presence of various internal anti-block and slip additives which are necessary to improve handling properties. An oriented PET film without such additives will have a very smooth surface but cannot generally be handled, i.e., wound and rewound, without introducing excessive wrinkling. However, a practical film with preferred smoothness can be prepared by selectively treating only one surface with a selected antiblock agent, leaving the other surface untreated and smooth. Application of such an agent to at least one surface of a film is described in U.S. patent 3,808,027, the disclosure of which is incorporated herein by reference. A preferred commercially available substrate is Mylar® polyester film, type D, which has a surface roughness of 2-7 nm. It is believed that films with this superior level of smoothness provide better adhesion of the glass coating to the film, leading in certain instances to improved barrier properties and improved stability under retort conditions. It is preferred that the glassy coating be applied to the smooth side of such film.

Vacuum deposition of SiO₂ materials to form a coating or layer on a substrate is a conventional process such as by evaporation of the silicon oxide or sputtering. The evaporative process can be performed using thermal processes such as resistance heating, electron beam heating, or induction heating of the silicon oxide source. This causes the source to vaporize and then deposit on the resin substrate positioned in the vacuum chamber. In sputtering, an ion beam or magnetically confined plasma (magnetron) displaces material from the silicon oxide target, causing this displaced material to deposit on the resin substrate.

Sometimes these processes are referred to as vapor deposition, but the term "vacuum deposition" is used herein to describe these processes, since both the evaporative process and sputtering are carried out in a vacuum. The background pressure of oxygen present in the vacuum chamber may be altered as desired to control the oxygen to silicon ratio in the SiO₂ deposited layer.

The area of the substrate to be coated is positioned either in a continuous process or batch process in a chamber within which a vacuum is drawn. When the resin substrate is in the form of a film, the film may be made unaccessible to the vacuum deposition on one surface of the film so that only the opposite surface receives the vacuum deposited layers. When the resin substrate is in the form of a container, the entire container can be positioned within the vacuum chamber. The surface of the resin substrate, exterior or interior, facing the source receives the vacuum deposited coatings. The resin substrate can be repositioned and the coating operations repeated to cover additional surface, such as the opposite side, of the substrate. U.S. Patent 4,552,791 discloses a vacuum deposition arrangement for coating containers with SiO or other oxides, disclosing titanium oxide and aluminum oxide. This vacuum deposition arrangement can be used in the practice of the present invention.

The SiO₂ source and the dopant source are placed in the vacuum chamber and then exposed to the evaporative or sputtering process. The oxide and dopant displaced from the source(s) then form the coating desired on the resin substrate. The thickness of the coating is determined by the residence time of the substrate in the chamber and/or the active area of silicon oxide and dopant sources present in the chamber relative to the area of substrate present in the chamber and the energy applied per unit of target area.

Sufficient vacuum is drawn within the vacuum chamber that the mean free path of the silicon oxide and dopant molecules is sufficient to reach and therefore enable deposition of the glassy layer on the resin substrate. The vacuum used in the experiments described in the Examples herein generally falls within the range of about 1 to 100 microtorr (760 torr = 1 atm). One skilled in the art will know how to select the proper vacuum for a given vacuum deposition process, including its conditions of operation.

### SiO₂ - Dopant Layer

In this embodiment of the present invention a layer of doped SiO₂ glass can be applied directly to the substrate. The doped SiO₂ glass coating should be thick enough to adequately improve the barrier properties of the substrate, but not so thick as to seriously degrade transparency of the substrate or to result in loss of durability or flexibility of the glass, when the substrate is a film. Typically coatings of about 20 to about 500 nm are suitable, depending on the effectiveness of the particular glass composition. A thickness of about 50 to about 350 nm is preferred, although for some compositions a thickness of about 200 to 400 nm is desirable; for particularly effective compositions, a coating of 50 to 100 nm is quite adequate.

The doped glass coating is based on silicon dioxide. The actual stoichiometry of the glass in this layer may vary from the nominal oxygen-silicon ratio of 2:1 of SiO₂, for example, due to reactions which may occur during the vacuum deposition process. A source of silicon dioxide and dopant metal (either in different sources or comixed in a single source, either as a powder, a metal wire, or vitrified into a silica glass) is placed in the vacuum chamber and vaporized by heating with an electron beam or a resistance or induction heated furnace, or by sputtering or reactive sputtering by an ion beam or a magnetron source. The silicon dioxide, along with the dopant metal, condenses to form the desired coating.

The dopant can be incorporated into the SiO₂ layer either by evaporating a single source of a physical or fused mixture of the dopant and SiO₂, or by co-depositing the dopant and the SiO₂ from two or more sources simultaneously. In both cases, the dopant can be in a metallic form or in the form of an oxide, silicide, silicate, halide, or carbonate. In the case of depositing from a single source, the proportion of the dopant present in the deposited SiO₂ layer may vary from the composition of the source. Such proportion can be determined for a particular source composition and conditions of vacuum deposition and can be adjusted to the proportion desired by adjustment of the source composition. In case of either deposition method, the composition of the coating can be determined by analysis of atomic absorption using inductively coupled plasma (ICP), which is a conventional analysis procedure. This analysis primarily detects the elemental metal in the SiO₂. Therefore, the weight percents of dopant disclosed herein are based on the elemental metal of the metal dopant. Thus decomposition products, e.g. CO₂ from carbonates, which do not become part of the SiO₂ layer are not included in weight percents of dopant in that layer. The weight percents of dopant disclosed herein refer to the composition of the SiO₂ layer unless otherwise indicated. These same weight percents may, however, be present in the source(s) for vacuum deposition (co-deposition), and as previously described, the resultant composition of the SiO₂ layer for the vacuum deposition conditions used can then be determined, and the source composition can be adjusted in subsequent runs to obtain the final composition desired. More often, the source composition will be adjusted to provide the barrier properties desired for the multilayer structure rather than analyzing the SiO₂ layer for its dopant content.

The silicon dioxide coating of the present invention is "doped," as described above, with a high level of at least one of a select group of metals. The term "doping" is used herein to describe a deposition with silicon dioxide of a relatively high level of metal, typically 0.5 to about 25 weight percent, as measured in the source, or about 0.5 to about 30 weight percent as measured as metal in the glass coating itself.

The oxidation state of the metal as it resides in the coating matrix of silicon dioxide is not necessarily clearly understood or well defined. Thus if an elemental metal is used as the source for the dopant, the deposited metal atoms or particles may interact with the oxygen atoms of the matrix to form a partially or completely oxidized material. Alternatively, if an oxide of the metal is used as the source, it is not necessarily known nor is it necessarily important whether the metal is deposited into the glassy matrix as the oxide or as the elemental metal. It appears that either the elemental metal or an oxide of the metal or certain other metal compounds, regardless of oxidation state can be suitably used as the source of the dopant metal for the present invention. Such possibilities and equivalents thereof are included within the scope of the present invention when terms such as "metal dopant" or the like are used. The selection of an appropriate source for metal dopant will be within the abilities of one skilled in the art and will be determined by such factors as relative cost and ease of handling. In many cases the metal oxide or especially the elemental metal will be preferred.

Suitable metal dopants for the present invention include antimony, chromium, cobalt, copper, indium, iron, manganese, tin, titanium, tungsten, zinc, and zirconium. Preferred metals include chromium, manganese, zinc, and most preferably copper and tin. When one or more of these metals are present, the barrier property of the glass coating and of the structure as a whole is greatly improved. Surprisingly it has been found that many other metals do not show this sort of improvement. Among the metals that are not particularly effective at comparable levels are calcium, vanadium, lithium, nickel, molybdenum, gold, germanium, and selenium. Sulfur is similarly not effective. It is surprising that these elements appear in the same regions of the periodic table with the metals that are effective. The chemical phenomenon that distinguishes between these groups of metals is not understood. It is noted that the metals which form a part of the present invention are generally located to the right of Column II of the Periodic Table, that is, to the right of the alkali metals and the alkaline earth metals.

When a metal dopant from the metals of the present invention is used in the layer of silicon dioxide, the improvement in barrier properties can be dramatic. One customary measurement of barrier properties of a film is its oxygen transmission rate ("OTR", ASTM D-3985-81(1988)) expressed as mL oxygen passage/m²-day-atmosphere. A film of ordinary untreated PET, 23 micrometers thick, typically has an OTR of 75-90; that of a 12 micrometer film is typically 150-180. Addition of a 300 nm coating of SiO₂ reduces the OTR somewhat, to about 10-80. Addition of one or more of the metals of the present invention can routinely reduce the OTR to less than 5. In copper, the most preferred case, addition of even 1 percent to the SiO₂ (measured in the source) can reduce the OTR to as low as 0.5, while use of 5-10 percent copper can result in values as low as 0.3. Use of tin, which is also preferred, provides values nearly as low.

The effectiveness of the barrier properties depends not only on the type of metal involved but also, of course, on the thickness of the glass layer. The effect of total glass thickness can be factored out by focusing on the oxygen permeation value ("OPV," mL-mm/M²-day-atm), which provides a measure of the inherent barrier properties of the glass. A coating of SiO₂ alone exhibits an OPV on the order of 0.1 or higher. The coatings of the present invention exhibit OPV of typically 3 x 10⁻³ or lower, and in the best cases as low as 1 x 10⁻⁴ or better.

The OTR or OPV of a particular film or composition is not a simple linear function of dopant concentration. For each metal dopant there appears to be a certain minimum concentration required to achieve a significant improvement, a concentration range, varying somewhat with the metal but generally within about 0.5 to about 30 weight percent (calculated as elemental metal in total glass layer), where the invention is effective, and a region of higher metal concentration within which the effectiveness diminishes or the optical transparency of the film is adversely affected.

In all embodiments of the present invention, an additional protective layer for the SiO₂ layer can be added (with or without dopant). Such a layer can be selected from any plastic resin that adheres to the SiO₂ layer or that adheres via an intervening adhesive layer. Examples of protective layers include a layer of polyester (adhered to the SiO₂ layer via an adhesive), polyamides, acrylonitrile copolymers, polyvinylidene chloride, polyethylene, polypropylene, ethylene vinyl acetate copolymer, ethylene/acrylic or methacrylic acid copolymer and ionomer. The protective layer can be applied to the SiO₂ layer by conventional processes such as adhesive or thermal laminating or extrusion coating simultaneous with extrusion of the intervening adhesive, if any. The protective layer can also be provided by solvent or dispersion coating onto the SiO₂ layer, using multiple coatings if thickness greater than achievable by single coating is desired. The thickness of the protective layer will generally be about 0.5 to 100 micrometers, preferably 10 to 25 micrometers (0.010 to 0.025 mm). In one embodiment, the protective layer is biaxially oriented PET film (0.0234 mm thick), which is laminated to the exposed surface of the SiO₂ layer via a co-polyester adhesive resin available as Adcote 506-40 (2.7 g/m²) from Morton Chemicals and a nip roll heated at 120°C for pressing the film and laminate structure against one another.

Films and structures of the present invention are useful as a wide variety of packaging, from rigid to semi-rigid containers to packaging film where barrier properties towards oxygen and other materials are desired. The particular use will dictate the choice and shape of the resin substrate. For packaging films, the resin substrate will be in the form of a film having, for example, a thickness of 10 to 150 micrometers, often 12 to 50 or preferably 15 to 25 micrometers. The high light transmission and colorless appearance of packaging serves as a good showcase for food packaged therein, and the high barrier properties of such packaging provides excellent preservation of this food.

Examples of the present invention are as follows (parts and percents are by weight unless otherwise indicated):

### Examples 1-136

Silicon dioxide was mixed with a dopant material and loaded into the hearth (crucible) of an electron beam evaporator of the single crucible bent beam source type as sold by a variety of manufacturers including Denton Vacuum of Cherry Hill, NJ. A thin film was formed from this mixture onto the smoother surface of a 23 micrometer (92 gauge) PET film (Mylar® type D) by electron beam evaporation from the mixture. The accelerator voltage was continuously adjusted to sweep the beam across the material in the source crucible to give uniform erosion of the crucible's contents. The filament current (and hence the beam current) was adjusted to provide a high deposition rate, resulting in a relatively high background pressure of about 1.3 X 10⁻² Pa (about 1 X 10⁻⁴ torr). This pressure was not so high as to cause premature arc-over of the electron beam gun. The thickness of the deposit was monitored by a calibrated oscillating quartz crystal monitor such as manufactured by Veeco Instruments Inc., Plainview, NY. The film (unless another grade is reported) had an average (RA) surface roughness of 2-7 nanometers. The coated film's oxygen transmission rate was measured using an "Ox-Tran 1000™" oxygen permeation device manufactured by Modern Control Inc. of Minneapolis, Minn. All data in Table I were obtained at 30°C at 80% relative humidity, using 100% oxygen at 1 atmosphere pressure (about 101 kPa). The results are reported in the Tables as oxygen transmission rate (mL/m²-day-atm). In addition the results are reported as oxygen permeation value (mL-mm/m²-day-atm) by subtracting the (minimal) barrier properties of the uncoated film and multiplying the result by the thickness of the glass coating.

The results for the first Examples, Table 1, Examples 1-11, illustrate the poor barrier properties of PET film treated with a layer of undoped silicon dioxide.

**TABLE I**

| Ex.a | Dopant | Thickness, nm | OTR | OPV X 10⁶ |
|---|---|---|---|---|
| C1 | none | 325 | 23.6 | 12054 |
| C2 | " | 300 | 84.3 | >100000 |
| C3 | " | 301 | 76.4 | >100000 |
| C4 | " | 303 | 77.1 | >100000 |
| C5 | " | 314 | 7.1 | 2517 |
| C6 | " | 315 | 62.1 | >100000 |
| C7 | " | 323 | 51.6 | 83026 |
| C8 | " | 355 | 10.1 | 4238 |
| C9^{b} | " | -- | 161.5 | -- |
| C10^{b} | " | -- | 72.4 | -- |
| C11^{b} | " | -- | 28.1 | -- |

| | | | | |
|---|---|---|---|---|
| a. Examples designated "C" are included for comparative purposes. | | | | |
| b. PET film having a surface roughness of 26-33 nm and a thickness of 12 micrometers. | | | | |
| -- indicates value not measured. | | | | |

The results in the next series of Examples, Table II, Examples 12-57, illustrate many of the metal dopants which are not a part of the present invention. Most of these dopants do not provide significant improvements in barrier properties in the concentration ranges examined, although a few do show improvement (e.g. MgF₂, MgO, BaO, disclosed in U.S. 4,702,963 along with CaO which does not show adequate activity). For reasons which are not fully understood, low levels of lithium borate, Li₂B₄O₇, also seem to be effective.

**TABLE II**

| Ex. | Dopant, | % | Thickness, nm | OTR | OPV X 10⁶ |
|---|---|---|---|---|---|
| C12 | Ag | 10 | 301 | 8.5 | 2944 |
| C13 | AgO | 10 | 300 | 5.9 | 1944 |
| | | | | | |
| C14 | BaO | 10 | 307 | 2.6 | 828 |
| C15 | " | 30 | 315 | 7.7 | 2743 |
| | | | | | |
| C16 | B₂O₃ | 3 | 326 | 80.3 | >100000 |
| C17 | " | 10 | 213 | 77.2 | >100000 |
| C18 | " | 10 | 327 | 83.4 | >100000 |
| | | | | | |
| C19 | Ca(BO₂)₂ | 10 | 290 | 74.7 | >100000 |
| C20 | " | 10 | 303 | 35.5 | 23832 |
| C21 | " | 25 | 239 | 82.5 | >100000 |
| C22 | " | 50 | 230 | 73.2 | >100000 |
| | | | | | |
| C23 | CaO | 10 | 301 | 6.0 | 1985 |
| C24 | " | 30 | 265 | 12.3 | 4042 |
| | | | | | |
| C25 | K₂O | 10 | 308 | 27.0 | 14319 |
| | | | | | |
| C26 | Li | 3 | -- | 80.6 | -- |
| C27 | Li₂B₄O₇ | 1 | 307 | 2.5 | 797 |
| C28 | " | 2 | 301 | 2.4 | 756 |
| C29 | " | 7 | 301 | 41.5 | 34897 |
| C30 | LiF | 1 | 301 | 30.1 | 17002 |
| C31 | " | 4 | 300 | 50.4 | 68597 |
| | | | | | |
| C32 | MgCl₂ | 2 | 301 | 51.7 | 78306 |
| C33 | " | 10 | 246 | 19.0 | 6639 |
| C34 | " | 10 | 246 | 23.3 | 8955 |
| | | | | | |
| C35 | MgF₂ | 1 | 303 | 20.6 | 9185 |
| C36 | " | 2 | 299 | 1.1 | 320 |
| C37 | " | 5 | 105 | 4.0 | 449 |
| C38 | " | 5 | 201 | 2.2 | 455 |
| C39 | " | 5 | 303 | 1.1 | 334 |
| C40 | " | 10 | 297 | 1.1 | 328 |
| C41 | " | 10 | 308 | 1.1 | 340 |
| C42 | " | 15 | 306 | 2.2 | 713 |
| C43 | " | 30 | -- | 10.2 | -- |
| C44 | MgO | 5 | 304 | 1.9 | 602 |
| C45 | " | 10 | 302 | 5.4 | 1766 |
| C46 | " | 35 | 215 | 1.6 | 341 |
| C47 | " | 35 | 306 | 1.6 | 486 |
| | | | | | |
| C48 | Na₂B₄O₇ | 4 | 321 | 29.9 | 17889 |
| C49 | " | 10 | -- | 57.2 | -- |
| C50 | " | 10 | 265 | 66.0 | >100000 |
| C51 | N₂SO₄ | 5 | 302 | 60.2 | >100000 |
| C52 | " | 20 | 304 | 70.3 | >100000 |
| C53 | Na+Al^{a} | | 301 | 73.1 | >100000 |
| C54 | Mo | 10 | 302 | 72.7 | >100000 |
| C55 | Ni | 10 | 299 | 55.8 | >100000 |
| C56 | Si | 10 | 304 | 3.3 | 1073 |
| C57 | " | 20 | 307 | 1.5 | 463 |

| | | | | | |
|---|---|---|---|---|---|
| a. A fused glass; exact composition unknown. | | | | | |

The next series of Examples, Table III, Examples 58-67, show certain metal compound dopants (AlF₃, CuCO₃, CuF₂, Cu₅Si, and WO₂) which are effective only at comparatively higher concentrations in the source, e.g., about 20%. It is believed that these materials evaporate at a slower rate than does SiO₂, resulting in lower actual concentrations in the films. Yet it is believed that when a sufficient amount of metal is deposited in the glass coating, the results nevertheless show significant improvement in barrier properties.

**TABLE III**

| Ex. | Dopant, | % | Thickness, nm | OTR | OPV X 10⁶ |
|---|---|---|---|---|---|
| C58 | AlF₃ | 2 | 302 | 19.5 | 8445 |
| C59 | " | 10 | 313 | 2.9 | 961 |
| C60 | CuCO₃ - Cu(OH)₂ | 5 | 302 | 15.3 | 6038 |
| 61 | CuCO₃ | 20 | 300 | 1.6 | 491 |
| C62 | CuF₂ | 5 | 273 | 9.8 | 3152 |
| C63 | Cu₅Si | 5 | 308 | 78.9 | >100000 |
| 64 | " | 20 | 302 | 1.9 | 588 |
| 65 | " | 20 | 302 | 0.9 | 275 |
| C66 | WO₂ | 5 | 286 | 79.9 | >100000 |
| 67 | WO₃ | 20 | 123 | 4.1 | 537 |

The last series of Examples, in Table IV, Examples 68-136, illustrate the results using metal dopants of the present invention. Concentrations of metal within the effective concentration ranges provide marked improvements in barrier properties. (In some of the examples using copper, the metal was added to the source material in the form of a wire; in other examples, as a powder. No consistent differences in the results were observed.)

**TABLE IV**

| Ex. | Dopant, | % | Thickness, nm | OTR | OPV X 10⁶ |
|---|---|---|---|---|---|
| C68 | Al | 2 | 303 | 1.9 | 595 |
| C69 | " | 10 | 303 | 1.3 | 403 |
| C70 | " | 10 | 311 | 1.6 | 494 |
| C71 | " | 15 | 312 | 4.5 | 1496 |
| C72^{a} | " | 30 | 321 | 14.3 | 5875 |
| | | | | | |
| 73 | Co | 10 | 214 | 0.9 | 196 |
| | | | | | |
| 74 | Cr | 10 | 303 | 1.3 | 408 |
| 75 | " | 20 | 302 | 1.9 | 603 |
| 76 | " | 30 | 300 | 0.7 | 207 |
| 77 | " | 30 | 302 | 1.3 | 387 |
| | | | | | |
| C78 | Cu | 1 | 300 | 8.1 | 2793 |
| C79^{a} | " | 1 | 300 | 124.0 | >100000 |
| 80 | " | 1 | 301 | 0.5 | 160 |
| 81 | " | 2 | 26 | 3.7 | 102 |
| 82 | " | 2 | 52 | 4.9 | 276 |
| 83 | " | 2 | 301 | 0.7 | 198 |
| 84 | " | 3 | 303 | 4.1 | 1334 |
| 85^{b} | " | 5 | -- | 0.7 | --- |
| C86 | " | 5 | 28 | 11.4 | 388 |
| 87 | " | 5 | 51 | 2.1 | 109 |
| 88 | " | 5 | 100 | 0.9 | 90 |
| 89 | " | 5 | 301 | 0.5 | 160 |
| 90 | " | 5 | 301 | 1.0 | 308 |
| 91 | " | 5 | 303 | 0.3 | 80 |
| 92^{c} | " | 5 | 305 | 2.6 | 829 |
| 93^{d} | " | 5 | 300 | 2.5 | 770 |
| 94^{e} | " | 5 | 295 | 2.2 | 658 |
| C95^{f} | " | 5 | 300 | 7.6 | 2428 |
| 96^{g} | " | 5 | 298 | 5.1 | 1712 |
| 97^{h} | " | 5 | 300 | 0.9 | 271 |
| 98^{h} | " | 5 | 302 | 1.8 | 567 |
| 99ⁱ | " | 5 | 301 | 1.5 | 527 |
| 100 | " | 5 | 301 | 0.9 | 289 |
| C101 | " | 5 | 303 | 60.3 | >100000 |
| C102 | " | 10 | 26 | 7.6 | 225 |
| 103 | " | 10 | 28 | 2.9 | 84 |
| 104 | " | 10 | 51 | 2.9 | 155 |
| 105 | " | 10 | 102 | 3.3 | 360 |
| 106 | " | 10 | 117 | 2.1 | 257 |
| 107 | " | 10 | 301 | 0.3 | 94 |
| 108 | " | 10 | 301 | 0.5 | 155 |
| 109 | " | 15 | 100 | 1.3 | 136 |
| 110 | " | 20 | 301 | 2.3 | 726 |
| 111 | " | 30 | 300 | 0.6 | 188 |
| C112 | Cu,B^{k} | 5 | 302 | 74.1 | >100000 |
| 113 | Cu(NO₃)₂ | 5 | 253 | 3.5 | 933 |
| | | | | | |
| 114 | Fe | 5 | 302 | 1.4 | 421 |
| 115 | " | 10 | 304 | 3.6 | 1174 |
| | | | | | |
| 116 | In | 5 | 302 | 1.6 | 509 |
| 117 | " | 20 | 309 | 1.5 | 476 |
| | | | | | |
| 118 | Mn | 10 | 302 | 0.6 | 189 |
| | | | | | |
| C119 | Pb | 10 | 330 | 1.5 | 497 |
| C120 | " | 20 | 309 | 1.7 | 526 |
| | | | | | |
| 121 | Sb | 5 | 190 | 5.8 | 1093 |
| | | | | | |
| 122 | Sn | 5 | 302 | 1.2 | 358 |
| 123 | " | 5 | 304 | 1.1 | 335 |
| 124^{j} | " | 5 | 130 | 1.6 | 256(est.) |
| 125 | " | 10 | 150 | 3.3 | 524 |
| 126 | " | 20 | 303 | 1.0 | 296 |
| 127 | " | 30 | 54 | 6.2 | 373 |
| C128^{a} | " | 30 | 54 | 146.8 | >100000 |
| | | | | | |
| C129 | 316 stainless steel^{l} | 10 | 305 | 5.3 | 1767 |
| | | | | | |
| 130 | TiO₂ | 10 | 300 | 3.8 | 1200 |
| | | | | | |
| 131 | Zn | 10 | 65 | 6.2 | 448 |
| 132 | " | 10 | 257 | 1.4 | 375 |
| 133 | " | 10 | 296 | 5.9 | 1913 |
| 134 | " | 20 | 304 | 2.2 | 688 |
| 135 | ZnO | 10 | 308 | 1.8 | 555 |
| 136 | {Zn | 5} | 301 | 3.9 | 1262 |
| | {Cu | 2} | | | |

| | | | | | |
|---|---|---|---|---|---|
| a. Borderline example; results subject to scatter. | | | | | |
| b. PET ilm "Melinex Type 442," surface roughness 10-18 nm. Coating thickness not measured. | | | | | |
| c. PET film having a surface roughness of 10-18 nm and a thickness of 14 micrometers. | | | | | |
| d. PET film having a surface roughness of 26-33 nm and a thickness of 12 micrometers. | | | | | |
| e. PET film having a surface roughness of greater than 26 nm and a thickness of 23 micrometers. | | | | | |
| f. Polyester film having a surface roughness of 41-49 nm and a thickness of 12 micrometers. | | | | | |
| g. Laminate of the coated film to a layer of uncoated 12 micrometer PET, using copolyester adhesive sheet. | | | | | |
| h. Laminate of the coated film to a layer of PET having a coated of heat sealable polyester copolymer, using copolyester adhesive sheet. | | | | | |
| i. Laminate of the coated film to a layer of PET coated with PVDC, using copolyester adhesive sheet. | | | | | |
| j. Substrate film poly(ethylene-2,6-naphthalene dicarboxylate with 30 nm undercoating of SiO. | | | | | |
| k. Fused silica glass containing Cu and B. | | | | | |
| l. 18% Cr, 11% Ni, 2.5% Mo, <0.1% C, remainder Fe. | | | | | |

### Examples 137-175

In the previous Tables the amount of dopant is listed as the amount present in the source in the hearth of the evaporator. The actual amount present in the glass coating was independently measured for some samples by atomic absorption. About 2-2.5 g of the sample is weighed accurately and charred with concentrated sulfuric acid, then dissolved by addition of concentrated nitric acid (aqua regia) and concentrated hydrofluoric acid and heating. The solution is diluted to 100 mL and analyzed by an Applied Research Laboratories 34000 simultaneous inductively coupled plasma analyzer or a Perkin Elmer 6500 (sequential) inductively coupled plasma analyzer. The amounts of the reported elements are calculated assuming that the dopant is the elemental metal and the matrix is SiO₂ (m.w. 60). The results are shown in Table V.

**Table V**

| Ex. | Dopant | Thickness (nm) | Source % | Coating % |
|---|---|---|---|---|
| C137 | Ag | 303 | 10.0 | 0.1 |
| C138 | B₂O₃ | 300 | 10.0 | 0.7 |
| C139 | MgF₂ | 302 | 5.0 | 0.6 |
| C140 | " | 301 | 10.0 | 1.0 |
| C141 | Mo | 301 | 10.0 | 13.4 |
| C142 | Na₂B₇O₄ | 302 | 10.0 | {2.1 Na} |
| | | | | {1.3 B } |
| C143 | Ni | 300 | 10.0 | 16.3 |
| | | | | |
| C144 | Al | 302 | 5.0 | 3.8 |
| C145 | " | 312 | 10.0 | 4.0 |
| C146 | " | 303 | 10.0 | <1.8 |
| | | | | |
| 147 | Fe | 298 | 5.0 | 7.4 |
| 148 | " | 304 | 10.0 | 13.5 |
| | | | | |
| 149 | Cr | 301 | 2.0 | 3.2 |
| 150 | " | 301 | 5.0 | 8.8 |
| 151 | " | 298 | 5.0 | 7.7 |
| 152 | " | 304 | 10.0 | 14.6 |
| 153 | " | 301 | 10.0 | 14.1 |
| | | | | |
| 154 | Cu | 147 | 5.0 | 10.5 |
| 155 | " | 299 | 5.0 | 0.0 |
| 156 | " | 300 | 5.0 | 1.5 |
| 157 | " | 307 | 5.0 | 8.7 |
| 158 | " | 310 | 5.0 | 7.4 |
| 159 | " | 152 | 10.0 | 15.8 |
| 160 | " | 299 | 10.0 | 8.7 |
| 161 | " | 303 | 10.0 | 6.2 |
| 162 | " | 305 | 10.0 | 21.2 |
| 163 | " | 276 | 10.0 | 17.1 |
| 164 | " | 301 | 20.0 | 30.2 |
| 165 | " | 153 | 20.0 | 29.8 |
| | | | | |
| 166 | Mn | 302 | 10.0 | 12.9 |
| | | | | |
| 167 | Sn | 301 | 2.0 | 8.8 |
| 168 | " | 152 | 5.0 | 12.2 |
| 169 | " | 304 | 5.0 | 24.3 |
| 170 | " | 302 | 5.0 | 17.5 |
| 171 | " | 301 | 5.0 | 12.0 |
| 172 | " | 271 | 5.0 | 8.8 |
| 173 | " | 153 | 10.0 | 14.6 |
| 174 | " | 306 | 10.0 | 24.7 |
| 175 | " | 285 | 10.0 | 26.4 |

The considerable scatter in the analysis of the coating composition is believed to arise from several sources including inaccuracies in the atomic absorption technique and the use of a laboratory evaporation method which uses a powder mixture of the components which may be less reproducible than desired. However correlations can be obtained which indicate actual coating compositions with a calculable uncertainty. The results relating to the metals included in the present invention nearly all indicate a higher concentration of the dopant metal in the coatings than in the source, with the possible exception of aluminum and silver. These trends are believed to be related to the relative vapor pressures of the metals compared with silicon dioxide. In particular the amount of copper or chromium in the glassy coating is about 1.4-1.5 times the amount in the source; the amount of tin in the coating is about 2.4-2.5 times the amount in the source. Metal compound dopants, for example some metal oxides, which may have lower vapor pressures than the elemental metals, may exhibit different correlations from those seen for the elemental metals. This phenomenon would explain the behavior of the examples in Table III, which require higher concentrations in the source to be effective. However, differences in vapor pressure cannot explain the ineffectiveness of such metals as nickel or molybdenum, which do appear in the coatings in amounts comparable to those for e.g. copper.

### Examples 176-209

The Examples in Table VI show the effect of increasing dopant levels on visible light transmission of films prepared according to the procedure of Examples 1-136 using a batch "bell-jar" process. The visible light absorbance (from which transmission is calculated) was measured using a Hewlett-Packard 8452A diode-array UV-vis spectrophotometer, having a bandwidth of 2 nm, wavelength reproducibility of ±0.05 nm, and stability of <0.002 absorbance units. The device measures the entire UV and visible absorbance spectrum simultaneously without scanning. The zero absorbance level was defined using air as the blank. For each film the absorbance spectrum from 360 to 740 nm was measured and stored on disk. The absorbances at 400 and 550 nm are reported. It is observed that percent transmission decreases with increasing dopant level; preferred films are those which retain at least about 70 percent transmission at 550 nm. Iron, chromium, and tin appear to be preferred in minimizing loss of optical transmission. Iron appears particularly suitable in this regard and actually appears to enhance the optical transmission.

**Table VI**

| Ex. | Dopant, | % | Thickness (nm) | % Transmission | |
|---|---|---|---|---|---|
| | | | | 400 nm | 550 nm |
| C176 | (no coating) | | | 85.01 | 88.71 |
| C177^{a} | (no coating) | | | 69.25 | 77.34 |
| | | | | | |
| C178 | none | -- | 323 | 81.85 | 83.18 |
| C179 | " | | 303 | 75.68 | 83.56 |
| | | | | | |
| C180 | MgF₂ | 5 | 201 | 88.10 | 88.10 |
| C181 | " | 5 | 306 | 88.98 | 90.19 |
| C182 | " | 10 | 301 | 86.90 | 92.17 |
| C183^{b} | SF₆ | 5 | 306 | 86.60 | 87.70 |
| | | | | | |
| C184 | Al | 5 | 304 | 76.21 | 80.91 |
| C185 | " | 15 | 312 | 38.90 | 75.86 |
| C186 | " | 30 | 321 | 1.45 | 28.18 |
| | | | | | |
| 187 | Cr | 5 | 304 | 84.96 | 88.73 |
| 188 | " | 10 | 152 | 82.45 | 82.42 |
| 189 | " | 10 | 303 | 85.62 | 90.07 |
| 190 | " | 20 | 76 | 81.16 | 83.67 |
| 191 | " | 20 | 153 | 70.89 | 78.76 |
| 192 | " | 20 | 302 | 12.30 | 31.62 |
| | | | | | |
| 193 | Cu | 5 | 300 | 59.57 | 71.94 |
| 194 | " | 5 | 301 | 73.79 | 81.66 |
| 195 | " | 10 | 117 | 64.12 | 72.44 |
| 196 | " | 10 | 311 | 51.71 | 71.94 |
| 197 | " | 20 | 78 | 84.96 | 88.73 |
| 198 | " | 20 | 155 | 50.05 | 61.44 |
| 199 | " | 20 | 301 | 25.59 | 39.81 |
| 200 | " | 20 | 302 | 53.48 | 65.80 |
| | | | | | |
| 201 | Fe | 5 | 302 | 87.90 | 87.41 |
| 202 | " | 10 | 304 | 82.99 | 89.54 |
| | | | | | |
| 203 | Mn | 10 | 302 | 78.16 | 83.95 |
| | | | | | |
| C204 | Pb | 10 | 330 | 26.61 | 41.88 |
| | | | | | |
| 205 | Sn | 5 | 302 | 85.11 | 88.72 |
| 206 | " | 10 | 150 | 82.70 | 85.51 |
| 207 | " | 10 | 311 | 84.45 | 85.29 |
| 208 | " | 20 | 76 | 86.50 | 90.16 |
| 209 | " | 20 | 303 | 25.94 | 36.31 |

| | | | | | |
|---|---|---|---|---|---|
| a. Commodity PET film with internal slip additive, 24 micrometers thick. | | | | | |
| b. Coating prepared from lead glass - about 70% Pb. | | | | | |

### Example 210

In this Example, an SiO₂ underlayer was present to yield the following multilayer film structure: PET film/32 nm SiO₂/271 nm SiO₂ + 5% Cu (source compositions). The PET film was Mylar D. The vacuum deposition procedure of Example 210 was used and the retort procedure of Example 211 was used. The OTR of this structure after retorting was 92.5 ml/m² Day Atm. The structure was clear and transparent, giving no visual evidence that the oxygen barrier had failed. In addition, the SiO₂ layers were strongly adhered to the PET film as indicated by a peel strength of 144.5 g/cm exhibited by a nearly identical film structure.

## Claims (Claims for the following Contracting State(s): AT, BE, CH, DE, DK, FR, GB, GR, IT, LI, LU, NL, SE)

1. A structure having superior barrier properties, comprising:
(a) a polymeric substrate, and
(b) a glassy coating of silicon dioxide doped with at least one metal selected from antimony, chromium, cobalt, copper, indium, iron, manganese, tin, titanium, tungsten, zinc, and zirconium, said coating and dopant contained therein being present so that the quantity of metal is from 0.5 to 30 weight percent as measured as metal in the glass coating itself.

2. The structure of claim 1 wherein the glass coating has an oxygen permeation value of at most about 3000 X 10⁻⁶ mL-mm/day-m²-atm.

3. The structure of claim 1 or 2 wherein the thickness of the glassy coating is about 20 to about 500 nm.

4. The structure of claim 1, 2 or 3 wherein the glassy coating of silicon dioxide is doped with a metal selected from copper, chromium, manganese, tin and zinc.

5. The structure of claim 4 wherein the metal is copper.

6. The structure of claim 4 wherein the metal is tin.

7. The structure of any one of claims 1 to 6 wherein the optical density of said glassy coating retains at least about 70% optical transmission at 550 nm.

8. The structure of any one of claims 1 to 7 wherein the polymeric substrate has a surface smoothness such that the average height of roughness is less than about 50 nanometers.

9. The structure of any one of claims 1 to 8 wherein the polymeric substrate is a film of polyester or polyamide.

10. The structure of claim 9 wherein the polyester is oriented polyethylene terephthalate.

11. A process for imparting barrier properties to a polymeric substrate, comprising the steps of:
(a) selecting a polymeric substrate; and
(b) vacuum depositing directly or indirectly onto said polymeric substrate a glassy coating derived from silicon dioxide and at least one metal selected from antimony, chromium, cobalt, copper, indium, iron, manganese, tin, titanium, tungsten, zinc, and zirconium;
wherein the amount of said glassy coating and the amount of metal contained therein being such that the quantity of metal is from 0.5 to 30 weight percent as measured as metal in the glass coating itself.

## Claims (Claims for the following Contracting State(s): ES)

1. A process for imparting barrier properties to a polymeric substrate, comprising the steps of:
(a) selecting a polymeric substrate; and
(b) vacuum depositing directly or indirectly onto said polymeric substrate a glassy coating derived from silicon dioxide and at least one metal selected from antimony, chromium, cobalt, copper, indium, iron, manganese, tin, titanium, tungsten, zinc, and zirconium;
said coating and dopant contained therein being present so that the quantity of metal is from 0.5 to 30 weight percent as measured as metal in the glass coating itself.

2. The process of claim 1 wherein the glass coating has an oxygen permeation value of at most about 3000 X 10⁻⁶ mL-mm/day-m²-atm.

3. The process of claim 1 or 2 wherein the thickness of the glassy coating is about 20 to about 500 nm.

4. The process of claim 1, 2 or 3 wherein the glassy coating of silicon dioxide is doped with a metal selected from copper, chromium, manganese, tin and zinc.

5. The process of claim 4 wherein the metal is copper.

6. The process of claim 4 wherein the metal is tin.

7. The process of any one of claims 1 to 6 wherein the polymeric substrate has a surface smoothness such that the average height of roughness is less than about 50 nanometers.

8. The process of any one of claims 1 to 7 wherein the polymeric substrate is a film of polyester or polyamide.

9. The process of claim 8 wherein the polyester is oriented polyethylene terephthalate.

## Patentansprüche (Patentansprüche für folgende(n) Vertragsstaat(en): AT, BE, CH, DE, DK, FR, GB, GR, IT, LI, LU, NL, SE)

1. Struktur mit überlegenen Barriereeigenschaften, die folgendes umfaßt:
(a) ein polymeres Substrat und
(b) eine glasartige Beschichtung aus Siliciumdioxid, die mit wenigstens einem Metall dotiert ist, ausgewählt aus Antimon, Chrom, Cobalt, Kupfer, Indium, Eisen, Mangan, Zinn, Titan, Wolfram, Zink und Zirkonium, wobei die Beschichtung und das darin enthaltene Dotiermittel so vorhanden sind, daß die Menge an Metall, gemessen als Metall in der Glasbeschichtung selbst, 0,5 bis 30 Gew.-% beträgt.

2. Struktur nach Anspruch 1, worin die Glasbeschichtung einen Sauerstoff-Permeationswert von höchstens etwa 3000 x 10⁻⁶ ml-mm/Tag-m²-atm besitzt.

3. Struktur nach Anspruch 1 oder Anspruch 2, worin die Dicke der glasartigen Beschichtung etwa 20 bis etwa 500 nm beträgt.

4. Struktur nach Anspruch 1, 2 oder 3, worin die glasartige Beschichtung aus Siliciumdioxid mit einem Metall dotiert ist, ausgewählt aus Kupfer, Chrom, Mangan, Zinn und Zink.

5. Struktur nach Anspruch 4, worin das Metall Kupfer ist.

6. Struktur nach Anspruch 4, worin das Metall Zinn ist.

7. Struktur nach irgendeinem der Ansprüche 1 bis 6, worin die optische Dichte der glasartigen Beschichtung bei 550 nm wenigstens etwa 70 % optische Transmission beibehält.

8. Struktur nach irgendeinem der Ansprüche 1 bis 7, worin das Polymersubstrat eine solche Oberflächenglattheit besitzt, daß die durchschnittliche Rauhigkeitshöhe geringer ist als etwa 50 Nanometer.

9. Struktur nach irgendeinem der Ansprüche 1 bis 8, worin das Polymersubstrat eine Folie aus Polyester oder Polyamid ist.

10. Struktur nach Anspruch 9, worin der Polyester orientiertes Polyethylenterephthalat ist.

11. Verfahren zur Verleihung von Barriereeigenschaften an ein Polymersubstrat, das die Stufen umfaßt:
(a) Auswählen eines Polymersubstrates; und
(b) direktes oder indirektes Vakuumaufdampfen auf das Polymersubstrat einer glasartigen Beschichtung, die sich von Siliciumdioxid und wenigstens einem Metall, ausgewählt aus Antimon, Chrom, Cobalt, Kupfer, Indium, Eisen, Mangan, Zinn, Titan, Wolfram, Zink und Zirkonium, ableitet, worin die Menge der glasartigen Beschichtung und die Menge des Metalls, das darin enthalten ist, so ist, daß die Menge des Metalls 0,5 bis 30 Gew.-%, gemessen als Metall in der glasartigen Beschichtung selbst, beträgt.

## Patentansprüche (Patentansprüche für folgende(n) Vertragsstaat(en): ES)

1. Verfahren zur Verleihung von Barriereeigenschaften an ein Polymersubstrat, das die Stufen umfaßt:
(a) Auswählen eines Polymersubstrates; und
(b) indirektes oder direktes Vakuumaufdampfen auf ein Polymersubstrat einer glasartigen Beschichtung, die sich ableitet von Siliciumdioxid und wenigstens einem Metall, ausgewählt aus Antimon, Chrom, Cobalt, Kupfer, Indium, Eisen, Mangan, Zinn, Titan, Wolfram, Zink und Zirkonium;
wobei die Beschichtung und das darin enthaltene Dotiermittel, so vorhanden sind, daß die Menge an Metall, gemessen als Metall in der Glasbeschichtung selbst, 0,5 bis 30 Gew.-% beträgt.

2. Verfahren nach Anspruch 1, worin die Glasbeschichtung einen Sauerstoff-Permeationswert von höchstens etwa 3000 x 10⁻⁶ ml-mm/Tag-m²-atm besitzt.

3. Verfahren nach Anspruch 1 oder Anspruch 2, bei dem die Dicke der glasartigen Beschichtung etwa 20 bis etwa 500 nm beträgt.

4. Verfahren nach Anspruch 1, 2 oder 3, bei dem die glasartige Beschichtung aus Siliciumdioxid mit einem Metall dotiert ist, ausgewählt aus Kupfer, Chrom, Mangan, Zinn und Zink.

5. Verfahren nach Anspruch 4, bei dem das Metall Kupfer ist.

6. Verfahren nach Anspruch 4, bei dem das Metall Zinn ist.

7. Verfahren nach irgendeinem der Ansprüche 1 bis 6, bei dem das Polymersubstrat eine solche Oberflächenglattheit besitzt, daß die durchschnittliche Rauhigkeitshöhe geringer ist als etwa 50 Nanometer.

8. Verfahren nach irgendeinem der Ansprüche 1 bis 7, bei dem das Polymersubstrat eine Folie aus Polyester oder Polyamid ist.

9. Verfahren nach Anspruch 8, bei dem der Polyester orientiertes Polyethylenterephthalat ist.

## Revendications (Revendications pour l'(les) Etat(s) contractant(s) suivant(s): AT, BE, CH, DE, DK, FR, GB, GR, IT, LI, LU, NL, SE)

1. Une structure ayant des propriétés de barrière supérieures, comprenant :
(a) un substrat polymère, et
(b) un revêtement vitreux de bioxyde de silicium dopé avec au moins un métal choisi parmi l'antimoine, le chrome, le cobalt, le cuivre, l'indium, le fer, le manganèse, l'étain, le titane, le tungstène, le zinc et le zirconium, ledit revêtement et ledit dopant contenu dans celui-ci étant présents en sorte que la quantité de métal soit de 0,5 à 30 pour cent en poids, telle que mesurée en métal dans le revêtement vitreux lui-même.

2. La structure de la revendication 1, dans laquelle le revêtement vitreux a un coefficient de perméabilité à l'oxygène d'au plus environ 3000 × 10⁻⁶ ml-mm/jour-m²-atm.

3. La structure de la revendication 1 ou 2, dans laquelle l'épaisseur du revêtement vitreux est d'environ 20 à environ 500 nm.

4. La structure de la revendication 1, 2 ou 3, dans laquelle le revêtement vitreux de bioxyde de silicium est dopé avec un métal choisi parmi le cuivre, le chrome, le manganèse, l'étain et le zinc.

5. La structure de la revendication 4, dans laquelle le métal est le cuivre.

6. La structure de la revendication 4, dans laquelle le métal est l'étain.

7. La structure de l'une quelconque des revendications 1 à 6, dans laquelle la densité optique dudit revêtement vitreux conserve au moins environ 70 % de transmission optique à 550 nm.

8. La structure de l'une quelconque des revendications 1 à 7, dans laquelle le substrat polymère a un état lisse de surface tel que la hauteur moyenne de rugosité soit inférieure à environ 50 nanomètres.

9. La structure de l'une quelconque des revendications 1 à 8, dans laquelle le substrat polymère est une pellicule de polyester ou polyamide.

10. La structure de la revendication 9, dans laquelle le polyester est un polytéréphtalate d'éthylène orienté.

11. Un procédé pour conférer des propriétés de barrière à un substrat polymère, comprenant les étapes suivantes :
(a) choisir un substrat polymère ; et
(b) déposer sous vide, directement ou indirectement sur ledit substrat polymère, un revêtement vitreux formé à partir de bioxyde de silicium et d'au moins un métal choisi parmi l'antimoine, le chrome, le cobalt, le cuivre, l'indium, le fer, le manganèse, l'étain, le titane, le tungstène, le zinc et le zirconium ;
la quantité dudit revêtement vitreux et la quantité de métal contenu dans celui-ci étant telles que la quantité de métal soit de 0,5 à 30 pour cent en poids, telle que mesurée en métal dans le revêtement vitreux lui-même.

## Revendications (Revendications pour l'(les) Etat(s) contractant(s) suivant(s): ES)

1. Un procédé pour conférer des propriétés de barrière à un substrat polymère, comprenant les étapes suivantes :
(a) choisir un substrat polymère ; et
(b) déposer sous vide, directement ou indirectement sur ledit substrat polymère, un revêtement vitreux formé à partir de bioxyde de silicium et d'au moins un métal choisi parmi l'antimoine, le chrome, le cobalt, le cuivre, l'indium, le fer, le manganèse, l'étain, le titane, le tungstène, le zinc et le zirconium ;
ledit revêtement et ledit dopant contenu dans celui-ci étant présents en sorte que la quantité de métal soit de 0,5 à 30 pour cent en poids, telle que mesurée en métal dans le revêtement vitreux lui-même.

2. Le procédé de la revendication 1, dans lequel le revêtement vitreux a un coefficient de perméabilité à l'oxygène d'au plus environ 3000 × 10⁻⁶ ml-mm/jour-m²-atm.

3. Le procédé de la revendication 1 ou 2, dans lequel l'épaisseur du revêtement vitreux est d'environ 20 à environ 500 nm.

4. Le procédé de la revendication 1, 2 ou 3, dans lequel le revêtement vitreux de bioxyde de silicium est dopé avec un métal choisi parmi le cuivre, le chrome, le manganèse, l'étain et le zinc.

5. Le procédé de la revendication 4, dans lequel le métal est le cuivre.

6. Le procédé de la revendication 4, dans lequel le métal est l'étain.

7. Le procédé de l'une quelconque des revendications 1 à 6, dans lequel le substrat polymère a un état lisse de surface tel que la hauteur moyenne de rugosité soit inférieure à environ 50 nanomètres.

8. Le procédé de l'une quelconque des revendications 1 à 7, dans lequel le substrat polymère est une pellicule de polyester ou polyamide.

9. Le procédé de la revendication 8, dans lequel le polyester est un polytéréphtalate d'éthylène orienté.
